# EUROPEAN PATENT SPECIFICATION

(11) **EP 0 638 054 B1**
(45) Date of publication and mention of the grant of the patent: **02.07.1997**
(21) Application number: 93912272.7
(22) Date of filing: 22.04.1993
(51) Int. Cl.: C04B 35/00, H01B 1/06

(54) **METHOD FOR DISPERSION SPINNING OF SHEATHED ROD-IN-TUBE SUPERCONDUCTING COMPOSITES**
VERFAHREN ZUM DISPERSIONSSPINNEN VON PLATIERTEN STAB-ROHR SUPRALEITENDEN ZUSAMMENSETZUNGEN
PROCEDE PERMETTANT DE FILER PAR DISPERSION DES COMPOSITES SUPRACONDUCTEURS PROTEGES DU TYPE TIGE DANS TUYAU

(30) Priority: 28.04.1992 US 875917
(43) Date of publication of application: 15.02.1995
(73) Proprietor: E.I. DU PONT DE NEMOURS AND COMPANY, Wilmington Delaware 19898 (US)
(72) Inventor: ZAHR, George, Elias, Glen Mills, PA 19342 (US)
(74) Representative: Jones, Alan John
(86) International application number: US9303582
(87) International publication number: WO9322257

(56) References cited:
- EP-A- 0 306 034
- EP-A- 0 445 832
- JOURNAL OF THE CERAMIC SOCIETY OF JAPAN vol. 100, no. 2, February 1992, TOKYO, JP, pages 117 - 122, XP301679 SAKAI ET AL. 'FABRICATION AND PROPERTIES OF SUPERCONDUCTING WIRE FORMED BY EXTRUDING METHOD'
- JAPANESE JOURNAL OF APPLIED PHYSICS vol. 28, no. 10, October 1989, TOKYO,JP pages L1805 - L1808 , XP80193 ZHUANG ET AL. 'PREPARATION OF BI-PB-SR-CA-CU-O SUPERCONDUCTING FIBRES BY THE SOL-GEL METHOD'

## Description

### FIELD OF THE INVENTION

This invention is generally directed to manufacture of composite materials. More particularly, this invention is directed to manufacture of superconducting wires.

### BACKGROUND OF THE INVENTION

High temperature superconductors, that is, superconductors that have a critical temperature on the order of 90°K, are disclosed by Wu et al., Phys. Rev. Lett. 58, 908-910 (1987). These high temperature superconductors are based on the Y-Ba-Cu-O system. U.S. Patent 4,929,594 discloses a superconducting composition comprised of a crystalline phase of the formula Tl₂Ba₂CuO₆₊ₓ, wherein x is from 0 to about 0.5, that has a temperature above 90°K. Subramanian et al., Science 239, 1015-1017 (1988), disclose materials of the formula Bi₂Sr₃₋ₓCaₓCu₂O_{8-y} which show a resistivity drop at about 116°K and apparent zero resistivity at 91°K.

A wide variety of applications for superconducting materials has developed. These applications include power transmission and high-speed computer electronics. Superconductor materials have been used primarily in the form of sintered articles since elongated articles such as wire are difficult to form and have non-uniform properties. Known technologies of forming superconducting wire, as shown in U.S. Patent 4,980,964, employ powder-in-tube technology. This technology entails filling a metal tube with a powder of superconductive material, sealing the tube, and cold drawing the sealed metal tube until a predetermined wire size is achieved. The drawn wire is heat treated to assure crystallinity in the superconductor material. This technology, however, produces wire of short lengths and nonuniform properties.

An improvement over powder-in-tube technology is described in European Patent Application publication number 0 292 385. This publication describes manufacturing an elongated superconducting composite by kneading a mixture of powder of superconducting oxide with a binder while shaping the resulting kneaded paste into an elongated pre-form by an extruder or other device. The pre-form is heated continuously to remove the binder. The pre-form then is wrapped with a metallic sheet and sintered at elevated temperatures. While this method results in longer and somewhat more uniform superconducting wire, this method can change the phase content of the resulting sintered ceramic and thus sacrifice superconducting properties.

European Patent Application 306,034 shows a method of forming superconducting ceramics which have a metal cladding thereon. In an embodiment, preforms of plastic compositions of polymer, plasticizer, and ceramic material are bonded prior to firing with a blend of metal, polymer and plasticizer to yield a metal clad sintered ceramic article upon firing. This method, however, is susceptible to undesirable leaching of materials between superconducting material and the metal coating.

A need therefore exists for processes for manufacturing elongated superconducting ceramic, metal clad articles useful for wire application which provides increased lengths and uniformity, but which avoids the deficiencies of the prior art methods.

### SUMMARY OF THE INVENTION

This invention provides a continuous process for forming elongated, composite articles that preferably include superconducting materials, in a metallic sheath. The method entails forming an elongated shaped article from a mixture of ceramic powder and organic binder solution. The elongated article is coated with a mixture of metallic powder and an organic binder solution that is different from the binder solution employed with the ceramic powder. The metal coated article is heated to burn off the organic binder and to crystallize the ceramic powder to form an elongated metal coated composite article which is preferably superconducting.

### DESCRIPTION OF THE DRAWINGS

Figure 1 is a schematic drawing of a spin cell employed to form ceramic fibers for subsequent coating with metal.

Figure 2 is a schematic drawing of an apparatus for producing metal coated superconducting ceramic wire.

Figure 3 is a schematic cross sectional view of a superconducting wire in accordance with this invention.

### DETAILED DESCRIPTTON OF THE INVENTION

Superconducting materials useful in the practice of this invention include ceramic materials that have a critical temperature (T_{c}), that is, the temperature at which resistivity drops to substantially zero, of preferably more than about 77°K. Such materials are described, for example, in Song et al., J. Mater. Res., Vol. 5, No. 1, 27-32 (1990) and in Pierre et al., J. of Appl. Phys., 68, 2296-2303 (1990). Ceramic materials that have a T_{c} >77°K include ceramic oxides from the Y-Ba-Cu-O system including Y₁Ba₂Cu₃O; the Tl-Ba-Cu-O system such as Tl₂Ba₂CuO₆₊ₓ wherein x = 0 to 0.5; from the Bi-Sr-Ca-Cu-O system such as Bi₂Sr₃₋ₓCaₓCu₂O_{8-y} where x - 0.4 to 0.9 and 0 < y < 1; and from the Bi-Pb-Sr-Ca-Cu-O system such as Bi_{1.6}Pb_{0.4}Sr_{1.6}Ca_{2.0}Cu_{2.8}O_{9.2+x} and Bi_{1.8}Pb_{0.4}Sr_{2.0}Ca_{2.2}Cu_{3.0}O_{10.3+x}, where x = 0.1 to 0.5.

Generally, the superconducting wire material provided by the invention can be made by mixing a solution of organic binder with the superconducting ceramic material. The resulting mixture of superconducting ceramic and binder is shaped into preforms which are coated with a mixture of metal and a solution of binder to provide a superconducting ceramic-metal composite. The solvent employed in binder solutions of the mixture of metal and binder is distinct from the solvent employed in the binder used for the ceramic. Typically, either solution or vapor deposition methods may be employed to apply the metal coating to the ceramic metal composite. The metal coated ceramic is heat treated to remove organic binders to yield an elongated metal coated superconducting product.

Generally, commercially available organic binders or mixtures thereof may be employed with both the ceramic and the metallic materials. Preferably, however, the organic binders employed burn off without yielding any residue. Organic binders useful to form superconducting ceramic, metal clad articles in accordance with this invention may include cellulose acetate, cellulose acetate butyrate, poly(vinyl alcohol), poly(ethylene oxide), poly(vinyl butyral), poly(methyl methacrylic acid), poly(methyl methacrylate), methyl cellulose, poly(isobutylene), and poly(propylene carbonate), preferably polyethylene oxide; most preferably poly(propylene carbonate). Preferably, substantially the same organic binders are employed with both the ceramic oxide and the metal powders. Different binders, however, may be employed between the ceramic powder and the metal coating provided that the binders dissolve in different solvents.

The amount of binder in the mixture of ceramic and binder, based on the total volume of the binder and ceramic material, but excluding any solvent, may vary from 20% to 80%. Preferably, the amount of binder can vary from 30% to 45% by volume. Similarly, the amount of binder in the mixture of binder and metal may vary from 20% to 80% by volume. Preferably, the volume percent of binder in the mixture of binder and metal may vary from 30% to 45%.

In order to provide an intimate mixture of organic binder either with the ceramic or metal powder, the binder is mixed with an organic solvent that is at least a partial solvent for the binder. Solvents useful in this invention include both polar and nonpolar solvents. Useful solvents, therefore, include ethylene glycol, methyl ethyl ketone, cyclohexanone, acetone, ethyl acetate, methanol, glycerol and water, preferably, methyl ethyl ketone. Solvents employed for the organic binder that is admixed with the metal powder, however, are not solvents for the organic binder employed with the ceramic oxide. The solvent chosen should at least partially dissolve the binder, e.g., polar solvents should be employed for polar binders.

Generally, surfactants may be incorporated with the mixture of solvent and binder which are employed with the ceramic and metal powders. Surfactants which may be employed in this invention include long chain organic acids, such as oleic acid, and polyacrylic acid, fatty acid esters, and fatty acid alkoxylates, preferably fatty acid alkoxylates.

The metal powder employed to coat the ceramic preform may include ductile conducting metals. Suitable metals include silver, gold, platinum, copper, or mixtures thereof, preferably, silver.

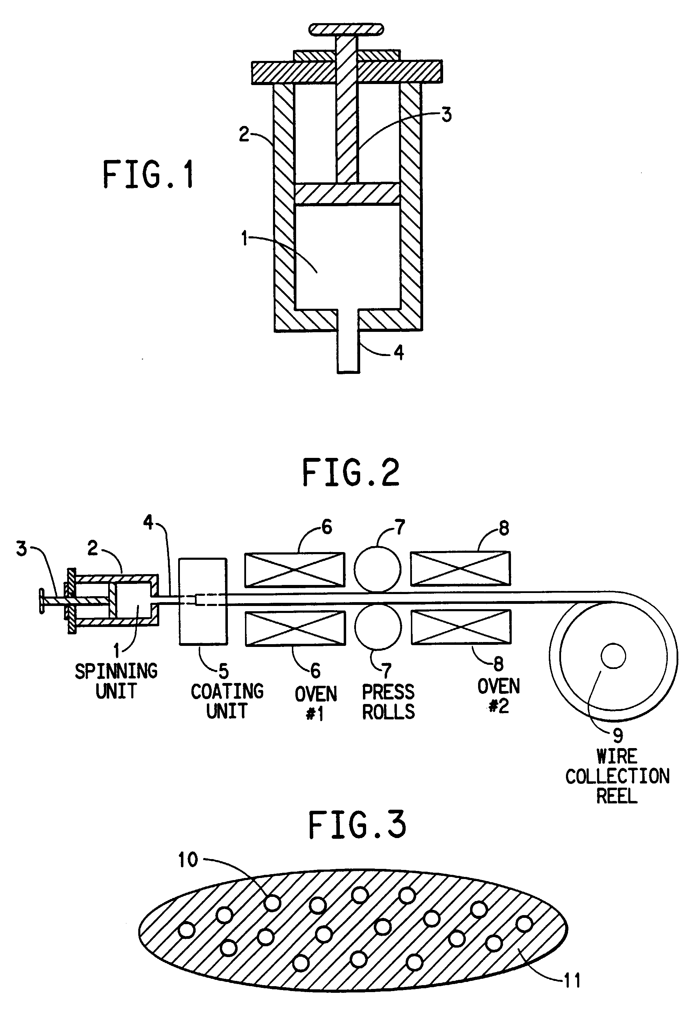

Composite articles of superconducting ceramic powder and organic binder which are coated with metal prior to heat treating readily can be formed by known techniques for manufacturing continuous ceramic fibers. See, for example, Weddell, J. Text. Inst., 1990, 81 No. 4, pp. 333-359. Preferably, the composite articles are manufactured in accordance with the method of Figure 1.

Referring to Figure 1, a mixture **1** of ceramic powder and organic binder is placed into spin cell **2**. Mixture **1** is pressed by piston **3** for extrusion through nozzle **4** to provide a continuous elongated strip. The strip can be collected by winding onto a spool or otherwise deposited in an elongated container (not shown).

Figure 2 illustrates an apparatus for performing the process of the invention in a continuous manner. As shown in Figure 2, the ceramic organic binder mixture **1** is placed into spin cell **2** and extruded through nozzle **4** by piston **3** to provide at least one ceramic fiber. The fiber is passed to coating unit **5** to apply a coating of a mixture of metal and organic binder to the fiber. Coating unit **5** can be any commercially available coating unit such as an electric wire coater or a fiber reinforced plastic tow prepreger made by Cincinnati Milicron.

Generally, the coating of metal and organic binder may be applied to the ceramic fiber in a wide range of thicknesses provided that all the ceramic fibers are coated. The thickness of metal coating may vary from 20 x 10⁻⁶ m to 2 x 10⁻³ m, preferably, 2 x 10⁻⁴ m. After the metal coating has been applied to the fiber, the coated fiber is passed through oven **6** to burn off the organic binders, crystallize the ceramic, and to densify the metal coating. Generally, the heat treatment employed in oven **6** will vary with the specific composition of binder, ceramic material, and metal. Specific heat treatment temperatures, atmospheres, and times can readily be determined in accordance with well known procedures to provide the desired superconducting phase of the ceramic oxide material.

The resultant, metal clad, superconducting ceramic fibers may be employed directly in applications such as magnets, powerlines, etc. Alternatively, the metal clad, superconducting fibers, may be passed through press rolls, plates, or dies **7** to further densify the fiber. In that event, the densified fibers then again are passed through a second oven **8** where they are further heat treated to enhance the current carrying capability of the fiber. The resulting fibers then may be collected by a collecting means such as spool **9** or a similar device.

The metal coated, superconducting ceramic fibers of the invention can be formed into a variety of configurations where either a single fiber or a plurality of fibers of superconducting ceramic fibers are embedded in or are coated by metal. The fibers can be round, elliptical or rectangular. Figure 3 shows a cross-sectional view of an article wherein a plurality of ceramic fibers **10** are combined into a bundle that is coated by metal **11**.

The following non-limiting example illustrates the invention.

### EXAMPLE 1

### PREPARATION OF MIXTURES OF CERAMICS AND BINDERS

A mixture of ceramic oxide and binder is prepared as follows: In a first container, a dispersion of oxide powder is prepared by mixing 10 g of Bi_{1.6}Pb_{0.4}Sr_{1.6}Ca_{2.0}Cu_{2.8}O powder in 50 ml of methyl ethyl ketone. Two drops of a commercially available surfactant, Sotex CW (Marton Chemical) is thoroughly mixed with the dispersion. In a second container, a solution of 1.4 g of poly(propylene carbonate) binder in 20 ml of methyl ethyl ketone is made. This solution is mixed with the dispersion of the oxide powder. The methyl ethyl ketone is partially evaporated by heating until the mixture forms a gummy paste.

### FORMING ELONGATED FIBERS

The gummy paste formed above is inserted into a conventional stainless steel spin cell that has an inside diameter of 1/2 inch (1.27 cm), as schematically shown in Figure 1. A piston is inserted into the spin cell to extrude the paste, and the spin cell is placed into a conventional spin unit. A spinneret is added to the spin cell to enable formation of fibers. The speed of the spin unit is adjusted to provide fibers from the spinneret. When spinnerets with openings of less than 1/8-inch (0.32 cm) diameter are employed, the extruded fibers are collected onto a 6-inch (15.2 cm) diameter bobbin. When larger hole size spinnerets are used, the extruded fibers may be collected onto a tray. In either case, the collected fibers are dried at room temperature.

### PREPARATION OF METAL COATED CERAMICS

A silver paste for coating the ceramic fibers formed above is prepared by mixing 2.0 g of commercially available silver powder, 0.24 g of poly(ethylene oxide) of an average molecular weight of about 600,000, and 5 ml of methanol.

The extruded ceramic fibers prepared above are uniformly coated with the silver paste by dipping the ceramic fibers in the silver paste and evaporating the solvent.

### HEAT TREATMENT AND FORMATION OF METAL-COATED, COMPOSITE SUPERCONDUCTING WIRE

The metal coated ceramic fibers prepared above are heated in air to remove the organic binder: starting at 25°C, the temperature is increased at the rate of 3°C per minute to 520°C, whereupon the temperature is raised to 580°C over 5 hours. The temperature then is lowered to 520°C over 5 hours and further reduced at 3°C per minute to 120°C. The heat treated material then is pressed between two metal plates to form a metal coated, composite superconducting ceramic wire. The heat treated and pressed wire then is recoated by dipping in a silver paste to seal any possible openings in the first silver coating. The recoated fiber again is heat treated in air under the low temperature cycle initially used to remove the organic binders. The resulting metal coated ceramic wire is again pressed as above. The resulting wire then is heated to drive off any remaining organic binder from the oxide powder and silver paste to form a silver coated superconducting ceramic of Bi_{1.6}Pb_{0.4}Sr_{1.6}Ca_{2.0}Ca_{2.8}O. The heat treatment is performed in an atmosphere of 7% oxygen and 93% nitrogen by increasing the temperature from 25° to 842°C at a rate of 3°C per minute and holding at 842°C for 25 hours. The temperature then is lowered to 120°C at 3°C per minute.

## Claims

1. A method of manufacture of composite articles of ceramic bearing a metal coating comprising,
forming a first mixture of ceramic powder having a critical temperature of greater than 77°K and a first solution of organic binder into an elongated ceramic preform,
coating said preform with a second mixture of a powdered conducting metal and a second solution of organic binder that employs a solvent other than a solvent for the binder employed in said first solution of organic binder to provide a coated ceramic preform, and
firing said coated ceramic preform to yield a composite article of ceramic bearing a uniform metal coating thereon.

2. The method of Claim 1 wherein said ceramic is a superconducting ceramic oxide selected from the group Bi_{1.6}Pb_{0.4}Sr_{1.6}Ca_{2.0}Cu_{2.8}O_{9.2+x} and Bi_{1.8}Pb_{0.4}Sr_{2.0}Ca_{2.2}Cu_{3.0}O_{10.3+x}, where x = 0.1 to 0.5, and said metal is selected from the group silver, gold, platinum, copper, or mixtures thereof.

3. The method of any one of Claims 1 or 2 wherein said organic binders are selected from the group cellulose acetate, cellulose acetate butyrate, poly(vinyl alcohol), poly(ethylene oxide), poly(vinyl butyral), poly(methyl methacrylic acid), poly(methyl methacrylate), methyl cellulose, poly(isobutylene), and poly(propylene carbonate).

4. The method of any one of Claims 1 or 2 wherein said firing is at a temperature of less than 842°C.

5. The method of Claim 3 wherein said ceramic is Bi_{1.6}Pb_{0.4}Sr_{1.6}Ca_{2.0}Cu_{2.8}O_{9.2+x} where x = 0.1 to 0.5, and said metal is silver.

6. The method of Claim 3 wherein said ceramic is Bi_{1.8}Pb_{0.4}Sr_{2.0}Ca_{2.2}Cu_{3.0}O_{10.3+x} where x = 0.1-0.5.

7. The method of Claim 5 wherein said composite article includes at least one ceramic preform.

8. The method of any one of Claims 1 or 2 wherein said organic binder is at least 20% by volume in each of said first and second mixtures.

9. The method of either Claim 5 or 6 wherein said metal is silver and said binder is poly(propylene carbonate) .

## Patentansprüche

1. Verfahren zur Herstellung von Verbundgegenständen aus Keramik, die eine Metallbeschichtung trägt, umfassend
das Bilden eines ersten Gemischs aus Keramikpulver mit einer kritischen Temperatur von über 77°K und
einer ersten Lösung eines organischen Bindemittels in einer länglichen keramischen Vorform,
das Beschichten der Vorform mit einem zweiten Gemisch aus einem Metall und einer zweiten Lösung eines organischen Bindemittels, die ein anderes Lösungsmittel als das Lösungsmittel für das in der ersten Lösung eines organischen Bindemittels verwendete Bindemittel enthält, wobei man eine beschichtete keramische Vorform erhält, und das Brennen der beschichteten keramischen Vorform, so daß man einen Verbundgegenstand aus Keramik, die eine gleichmäßige Metallbeschichtung trägt, erhält.

2. Verfahren gemäß Anspruch 1, wobei es sich bei der Keramik um ein supraleitendes keramisches Oxid handelt, das aus der Gruppe Bi_{1,6}Pb_{0,4}Sr_{1,6}Ca_{2,0}Cu_{2,8}O_{9,2+x} und Bi_{1,8}Pb_{0,4}Sr_{2,0}Ca_{2,2}Cu_{3,0}O_{10,3+x} ausgewählt ist, wobei x = 0,1 bis 0,5 ist, und das Metall aus der Gruppe Silber, Gold, Platin, Kupfer oder Gemischen davon ausgewählt ist.

3. Verfahren gemäß einem der Ansprüche 1 oder 2, wobei die organischen Bindemittel aus der Gruppe Celluloseacetat, Celluloseacetatbutyrat, Polyvinylalkohol, Polyethylenoxid, Polyvinylbutyral, Polymethylmethacrylsäure, Polymethylmethacrylat, Methylcellulose, Polyisobutylen und Polypropylencarbonat ausgewählt sind.

4. Verfahren gemäß einem der Ansprüche 1 oder 2, wobei das Brennen bei einer Temperatur von weniger als 842°C erfolgt.

5. Verfahren gemäß Anspruch 3, wobei es sich bei der Keramik um Bi_{1,6}Pb_{0,4}Sr_{1,6}Ca_{2,0}Cu_{2,8}O_{9,2+x} handelt, wobei x = 0,1 bis 0,5 ist, und es sich bei dem Metall um Silber handelt.

6. Verfahren gemäß Anspruch 3, wobei es sich bei der Keramik um Bi_{1,8}Pb_{0,4}Sr_{2,0}Ca_{2,2}Cu_{3,0}O_{10,3+x} handelt, wobei x = 0,1 bis 0,5 ist.

7. Verfahren gemäß Anspruch 5, wobei der Verbundgegenstand wenigstens eine keramische Vorform umfaßt.

8. Verfahren gemäß einem der Ansprüche 1 oder 2, wobei das organische Bindemittel sowohl bei dem ersten als auch bei dem zweiten Gemisch wenigstens 20 Vol.-% ausmacht.

9. Verfahren gemäß Anspruch 5 oder 6, wobei das Metall Silber ist und das Bindemittel Polypropylencarbonat ist.

## Revendications

1. Un procédé de fabrication d'articles composites en céramique portant un revêtement en métal, selon lequel
on façonne un premier mélange de poudre céramique ayant une température critique supérieure à 77°K et d'une première solution de liant organique pour former une préforme céramique allongée,
on revêt ladite préforme d'un second mélange de métal et d'une seconde solution de liant organique qui emploie un solvant autre qu'un solvant pour le liant employé dans ladite première solution de liant organique, pour fournir une préforme céramique revêtue, et
on cuit ladite préforme céramique revêtue pour donner un article composite en céramique portant sur lui un revêtement métallique uniforme.

2. Le procédé de la revendication 1 dans lequel ladite céramique est un oxyde céramique supraconducteur choisi dans le groupe constitué de Bi_{1,6}Pb_{0,4}Sr_{1,6}Ca_{2,0}Cu_{2,8}O_{9,2+x} et de Bi_{1,8}Pb_{0,4}Sr_{2,0}Ca_{2,2}Cu_{3,0}O_{10,3+x}, où x = 0,1 à 0,5, et ledit métal est choisi parmi le groupe constitué de l'argent, de l'or, du platine, du cuivre, ou de leurs mélanges.

3. Le procédé de l'une quelconque des revendications 1 et 2 dans lequel lesdits liants organiques sont choisis dans le groupe constitué de l'acétate de cellulose, de l'acétobutyrate de cellulose, de l'alcool polyvinylique , du poly(oxyde d'éthylène), du butyral polyvinylique , du poly(acide méthylméthacrylique), du poly(méthacrylate de méthyle), de la méthylcellulose, du poly(isobutylène), et du poly(carbonate de propylène).

4. Le procédé de l'une quelconque des revendications 1 et 2 dans lequel ladite cuisson est effectuée à une température inférieure à 842°C.

5. Le procédé de la revendication 3 dans lequel ladite céramique est Bi_{1,6}Pb_{0,4}Sr_{1,6}Ca_{2,0}Cu_{2,8}O_{9,2+x} où x = 0,1-0,5 et ledit métal est l'argent.

6. Le procédé de la revendication 3 dans lequel ladite céramique est Bi_{1,8}Pb_{0,4}Sr_{2,0}Ca_{2,2}Cu_{3,0}O_{10,3+x} où x = 0,1-0,5.

7. Le procédé de la revendication 5 dans lequel ledit article composite comprend au moins une préforme céramique.

8. Le procédé de l'une quelconque des revendications 1 et 2 dans lequel ledit liant organique est à une concentration égale à au moins 20% en volume dans chacun desdits premier et second mélanges.

9. Le procédé de l'une ou l'autre des revendications 5 et 6 dans lequel ledit métal est l'argent et ledit liant est le poly(carbonate de propylène).
